# EUROPEAN PATENT APPLICATION

(11) **EP 4 761 507 A1**
(43) Date of publication of application: **17.06.2026**
(21) Application number: 25220615.6
(22) Date of filing: 04.12.2025
(51) Int. Cl.: H10D 30/65, H10D 84/83, H10D 30/66, H10D 62/832

(54) **MOSFET WITH MONOLITHICALLY INTEGRATED CURRENT SENSE**

(30) Priority: 14.12.2024 US 202463734049 P; 14.11.2025 US 202519389685
(71) Applicant: Semiconductor Components Industries, LLC, Scottsdale, AZ 85250 (US)
(72) Inventor: KOZELSKY, Adam, 74271 Hodslavice (CZ); FRANCHI, Jimmy Robert Hannes, 74598 Enköping, Uppland (SE); YANG, Jeongwoo, 10348 Goyang-si, Gyeonggi-do (KR)
(74) Representative: Manitz Finsterwald Patent- und Rechtsanwaltspartnerschaft mbB

(57) **Abstract**

A MOSFET device is disclosed. The MOSFET devices includes a MOSFET and a sense-FET monolithically integrated on a semiconductor die. A gate pad coupled to a MOSFET gate and a sense-FET gate, and a drain pad is coupled to a MOSFET drain and a sense-FET drain. The MOSFET device further includes a first source metal located above a MOSFET active area and coupled to source contacts of the plurality of MOSFET cells, and a source pad formed by a second source metal that is coupled to the first source metal. In addition, the MOSFET device includes a first current-sense metal located above a sense-FET active area and coupled to one or more source contacts of the sense-FET, and also includes a current-sense pad formed by a second current-sense metal that is coupled to the first current-sense metal and extends over a portion of the MOSFET active area.

## Description

This application claims the benefit of provisional patent application No. 63/734,049, filed December 14, 2024, which is hereby incorporated by reference herein in its entirety.

### TECHNICAL FIELD

The disclosure relates generally to semiconductor devices, and particularly to techniques for improving area utilization of power transistors.

### BACKGROUND

Power transistors may be used in power electronics, such as switching power converters and inverters. In some applications, a metal-oxide semiconductor field effect transistor (MOSFET or MOS transistor) may be formed as a discrete component included in an integrated circuit package. Bond wires may connect various terminals of the MOSFET die to the lead frame of the integrated circuit package. For example, a gate pad may be coupled to a gate terminal by a first set of one or more bond wires, and one or more source pads may be coupled to a source terminal by a second set of one or more bond wires. For vertical MOSFETs, a drain contact may be configured on the opposite side of the die as the respective gate and source pads, and may further couple to a drain terminal of the lead frame.

In some power MOSFET applications, a current-sense cell, such as a sense-FET, may be monolithically integrated on the same semiconductor die as the power MOSFET. The current-sense cell may be coupled to a current-sense pad on the semiconductor die. The current-sense pad may in turn be coupled to the lead frame by a further set of one or more bond wires. Inventors of embodiments of the present disclosure have recognized that such a current-sense cell and current-sense pad may consume area under which the active area of the device is excluded according to conventional techniques. Inventors of embodiments of the present disclosure have also recognized that such area consumption, at the expense of the active area of the MOSFET, may result in a larger size and cost to manufacture a MOSFET for a given on-state resistance value. Embodiments of the present disclosure may address one or more of these challenges.

### SUMMARY

The examples herein enable a power MOSFET with a monolithically integrated current-sense cell and improved area utilization.

According to one embodiment, a MOSFET device includes (i) a MOSFET comprising a plurality of MOSFET cells formed on a semiconductor die, (ii) a sense-FET monolithically integrated with the MOSFET on the semiconductor die, (iii) a gate pad coupled to a MOSFET gate and a sense-FET gate, (iv) a drain pad coupled to a MOSFET drain and a sense-FET drain, (v) a first source metal on a first metal layer, the first source metal located above a MOSFET active area and coupled to source contacts of the plurality of MOSFET cells, (vi) a source pad formed by a second source metal on a second metal layer, wherein the second source metal is coupled to the first source metal, (vii) a first current-sense metal on the first metal layer, the first current-sense metal located above a sense-FET active area and coupled to one or more source contacts of the sense-FET, and (viii) a current-sense pad formed by a second current-sense metal on the second metal layer, wherein the second current-sense metal is coupled to the first current-sense metal and extends over a portion of the MOSFET active area. In some embodiments, the semiconductor die is a silicon carbide semiconductor die. In the same or different embodiments, the MOSFET and the sense-FET are vertical FETs. In the same or different embodiments, the MOSFET and the sense-FET are NMOS devices. In the same or different embodiments, the MOSFET device further includes a dielectric insulating the first source metal from the first current-sense metal and the second current-sense metal. In the same or different embodiments, the MOSFET device further includes an isolation area between the MOSFET active area and the sense-FET active area. In the same or different embodiments, the isolation area includes a gap in the first metal layer separating the first source metal and the first current-sense metal, wherein the gap is filled at least in part by one or more dielectric layers insulating the first source metal and the first current-sense metal. In the same or different embodiments, the isolation area includes at least one dielectric layer insulating a plurality of underlying source regions from the first metal layer and the second metal layer. In the same or different embodiments, the MOSFET device further includes a gate runner formed on the first metal layer, wherein the gate runner couples the gate pad formed on the second metal layer to a patterned polysilicon layer forming the MOSFET gate and the sense-FET gate. In the same or different embodiments, the sense-FET is located at a distance from the gate runner such that a parasitic sense-FET gate resistance based on a resistivity of the patterned polysilicon layer provides for a switching transient time of the sense-FET that is faster than a switching transient time of the MOSFET.

According to another embodiment, a silicon carbide MOSFET device includes (i) a silicon carbide MOSFET comprising a plurality of vertical MOSFET cells, (ii) a sense-FET monolithically integrated with the silicon carbide MOSFET, (iii) a gate pad coupled to a MOSFET gate and a sense-FET gate, (iv) a drain pad coupled to a MOSFET drain and a sense-FET drain, (v) a first source metal on a first metal layer, the first source metal located above a MOSFET active area and coupled to source contacts of the plurality of vertical MOSFET cells, (vi) a source pad formed by a second source metal on a second metal layer, wherein the second source metal is coupled to the first source metal, (vii) a first current-sense metal on the first metal layer, the first current-sense metal located above a sense-FET active area and coupled to one or more source contacts of the sense-FET, and (viii) a current-sense pad formed by a second current-sense metal on the second metal layer, wherein the second current-sense metal is coupled to the first current-sense metal and extends over a portion of the MOSFET active area. In some embodiments, the silicon carbide MOSFET device further includes a dielectric insulating the first source metal from the first current-sense metal and the second current-sense metal. In the same or different embodiments, the silicon carbide MOSFET device further includes an isolation area between the MOSFET active area and the sense-FET active area. In the same or different embodiments, the isolation area includes a gap in the first metal layer separating the first source metal and the first current-sense metal, wherein the gap is filled at least in part by one or more dielectric layers insulating the first source metal and the first current-sense metal. In the same or different embodiments, the isolation area includes at least one dielectric layer insulating a plurality of underlying source regions from the first metal layer and the second metal layer.

According to another embodiment, a MOSFET device includes (i) a silicon carbide MOSFET comprising a plurality of vertical MOSFET cells, (ii) a sense-FET monolithically integrated with the silicon carbide MOSFET, (iii) a gate pad coupled to a MOSFET gate and a sense-FET gate, (iv) a drain pad coupled to a MOSFET drain and a sense-FET drain, (v) a first source metal on a first metal layer, the first source metal located above a MOSFET active area and coupled to source contacts of the plurality of vertical MOSFET cells, (vi) a first current-sense metal on the first metal layer, the first current-sense metal located above a sense-FET active area and coupled to one or more source contacts of the sense-FET, (vii) an isolation area between the MOSFET active area and the sense-FET active area, the isolation area including at least one dielectric layer insulating the first source metal from the first current-sense metal, (viii) a source pad formed by a second source metal on a second metal layer, wherein the second source metal is coupled to the first source metal, and (ix) a current-sense pad formed by a second current-sense metal on the second metal layer, wherein the second current-sense metal is coupled to the first current-sense metal and extends over a portion of the MOSFET active area. In some embodiments, the MOSFET and the sense-FET are vertical FETs. In the same or different embodiments, the at least one dielectric layer included in the isolation area further insulates a plurality of underlying source regions from the first metal layer and the second metal layer. In the same or different embodiments, the MOSFET device further includes a gate runner formed on the first metal layer, wherein the gate runner couples the gate pad formed on the second metal layer to a patterned polysilicon layer forming the MOSFET gate and the sense-FET gate. In the same or different embodiments, the sense-FET is located at a distance from the gate runner such that a parasitic sense-FET gate resistance based on a resistivity of the polysilicon layer provides for a switching transient time of the sense-FET that is faster than a switching transient time of the MOSFET.

### BRIEF DESCRIPTION OF THE DRAWINGS

A more complete understanding of the present embodiments may be acquired by referring to the following description taken in conjunction with the accompanying drawings, in which like reference numbers indicate like features.
FIG. 1 illustrates a schematic view of a MOSFET device in accordance with embodiments of the present disclosure.
FIG. 2 illustrates a top view of a MOSFET device in accordance with embodiments of the present disclosure.
FIG. 3 illustrates a cross-section view of a plurality of MOSFET cells in accordance with embodiments of the present disclosure.
FIG. 4A illustrates a top layout view of a MOSFET device in accordance with embodiments of the present disclosure.
FIG. 4B illustrates a cross-section view of a MOSFET device in accordance with embodiments of the present disclosure.
FIG. 4C illustrates a cross-section view of a MOSFET device in accordance with embodiments of the present disclosure.

### DETAILED DESCRIPTION

Details of one or more embodiments are set forth in the description below and the accompanying drawings. Other features will be apparent from the description, drawings, and from the claims. The embodiments disclosed should not be interpreted, or otherwise used, as limiting the scope of the disclosure, including the claims. In addition, one skilled in the art understands that the following description has broad application, and the discussion of any embodiment is meant to be exemplary of that embodiment, and not intended to intimate that the scope of the disclosure, including the claims, is limited to that embodiment.

Various terms are used to refer to particular system components. Different companies may refer to a component by different names, and this disclosure does not intend to distinguish between components that differ in name but not form and function. In the following discussion and in the claims, the terms "including" and "comprising" are used in an open-ended fashion, and thus should be interpreted to mean "including, but not limited to." Also, the term "couple" or "coupled" is intended to mean either an indirect or direct connection. Thus, if a first device couples to, or is coupled to, a second device, that connection between the first device and the second device may be through a direct connection or through an indirect connection via other elements and connections.

Further, although the terms "first," "second," and so forth may be used herein to describe various elements, these elements should not be limited by these terms. Terms such as "first" and "second" may be used merely to distinguish one element from another. For example, a first element could be termed a second element, and, similarly, a second element could be termed a first element, without departing from the scope of the present disclosure. Further, the identification of a "first" element, does not necessarily require the presence of a "second" element. As used herein, the term "and/or" includes any and all combinations of one or more of the associated listed items.

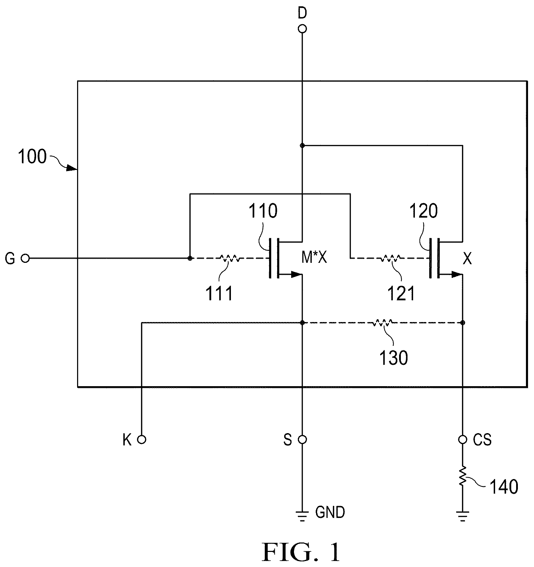

FIG. 1 illustrates a schematic view of MOSFET device 100 in accordance with embodiments of the present disclosure. MOSFET device 100 may include MOSFET 110 and sense-FET 120. In some embodiments, MOSFET 110 and sense-FET 120 may be NMOS devices (n-type MOSFETs) as shown in FIG. 1. In other embodiments, MOSFET 110 and sense-FET 120 may be implemented as PMOS devices (p-type MOSFETs).

As shown in FIG. 1, MOSFET device 100 may include a gate pad G coupled to a MOSFET gate of MOSFET 110 and to a sense-FET gate of sense-FET 120. MOSFET device 100 may further include a drain pad D coupled to a MOSFET drain of MOSFET 110 and a sense-FET drain of sense-FET 120. In addition, MOSFET device 100 may include a source pad S coupled to a MOSFET source of MOSFET 110, and may further include a current-sense pad CS coupled to a sense-FET source of sense-FET 120.

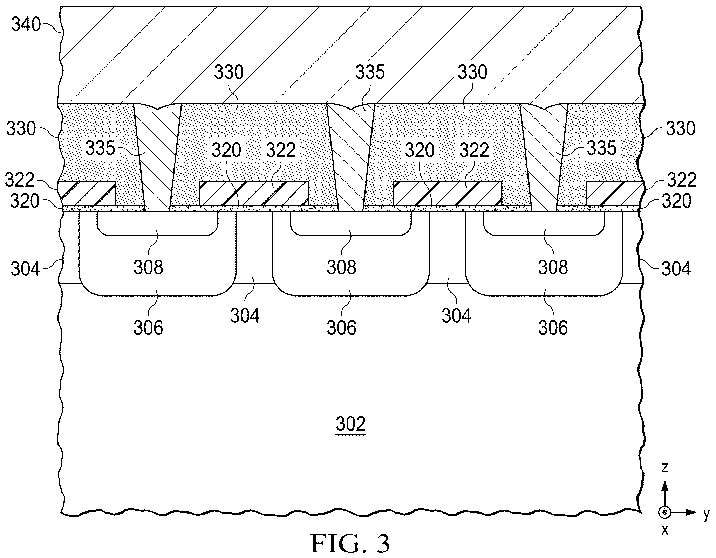

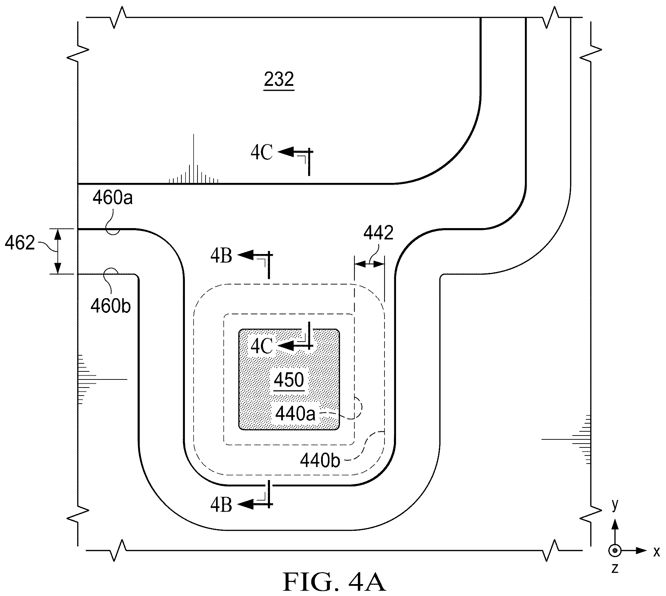

As explained in further detail below with reference to FIGS. 3 and 4A-4C, MOSFET 110 may include a plurality of MOSFET cells formed on a semiconductor die. Further, sense-FET 120 may include one or more MOSFET cells and may be monolithically integrated with MOSFET 110 on the semiconductor die. In some embodiments, the semiconductor die may be a silicon carbide semiconductor die. In such embodiments, MOSFET 110 may also be referred to as a silicon carbide MOSFET, and sense-FET 120 may be referred to as a silicon carbide sense-FET. In other embodiments, MOSFET 110 and sense-FET 120 may be monolithically formed together on any other suitable type of semiconductor die, such as but not limited to silicon (Si) or gallium nitride (GaN).

The plurality of MOSFET cells forming MOSFET 110 may have a collective size (a total gate width-to-length ratio) that is a multiple of M times larger than the collective size of the one or more MOSFET cells forming sense-FET 120. For example, sense-FET 120 may be formed with a plurality of MOSFET cells coupled in parallel to each other and having a total size (a total gate width-to-length ratio) of X. In turn, MOSFET 110 may be formed with a number of MOSFET cells coupled in parallel to each other and having a total size (a total gate width-to-length ratio) equal to a multiple of M times X, where M may be any suitable multiple such as 100, 200, 500, 1000, 2000, 5000, 10000, or more. Thus, when MOSFET 110 and sense-FET 120 are driven with gate-to-source voltages sufficiently above their respective gate-to-source thresholds, sense-FET 120 may conduct a current that is roughly proportional to the current conducted through MOSFET 110 at a ratio of 1:M. As shown in FIG. 1, the sense current conducted by sense-FET 120 may be output via current-sense pad CS to sense resistor 140. The voltage developed across sense resistor 140 due to the sense current may thus be used by further downstream circuitry (not shown in FIG. 1) to measure the current through MOSFET 110 as represented by the sense current. In some embodiments, such downstream circuitry may be incorporated with the same gate driver circuitry used to drive the gate pad G of MOSFET device 100.

As shown in FIG. 1, MOSFET device 100 may also include a bias resistance 130 between the MOSFET source of MOSFET 110 and the sense-FET source of sense-FET 120. As shown in FIGS. 3 and 4A-4C described below, the n-type source regions of the various cells forming MOSFET 110 and sense-FET 120 (for NMOS embodiments) may be included in the same p-well. Thus, bias resistance 130 may be effectively formed by the parasitic resistance of the resistivity of the shared p-well. In some embodiments, bias resistance 130 may have a resistance value that is at least one order (a factor of 10) higher than the resistance value of sense resistor 140. Such a ratio may reduce or eliminate any deviations in the sense ratio due to displacement current flowing from the sense-FET source of sense-FET 120 through bias resistance 130 as opposed to through sense resistor 140. A higher bias resistance 130 may be achieved, for example, by increasing the width of the isolation area (described below with reference to FIGS. 4A-4C) between the MOSFET active area in which MOSFET 110 is formed and the sense-FET active area in which sense-FET 120 is formed.

As shown in FIG. 1, MOSFET device 100 may also include a Kelvin pad K coupled to the MOSFET source of MOSFET 110. In some applications, the Kelvin pad K may be used as a low-current (or no-current) path through which external circuitry (not shown in FIG. 1) may sense the voltage directly at the MOSFET source of MOSFET 110.

In some embodiments, MOSFET device 100 may be included in an integrated circuit package. Gate pad G, drain pad D, and source pad S may be coupled, via respective sets of one or more bond wires or bond ribbons for example, to respective gate, drain, and source terminals of the integrated circuit package. Likewise, current-sense pad CS may be coupled, via one or more bond wires or bond ribbons, to a current-sense terminal of the integrated circuit package. Further, Kelvin pad K may be coupled, via one or more bond wires or bond ribbons, to a Kelvin terminal of the integrated circuit package.

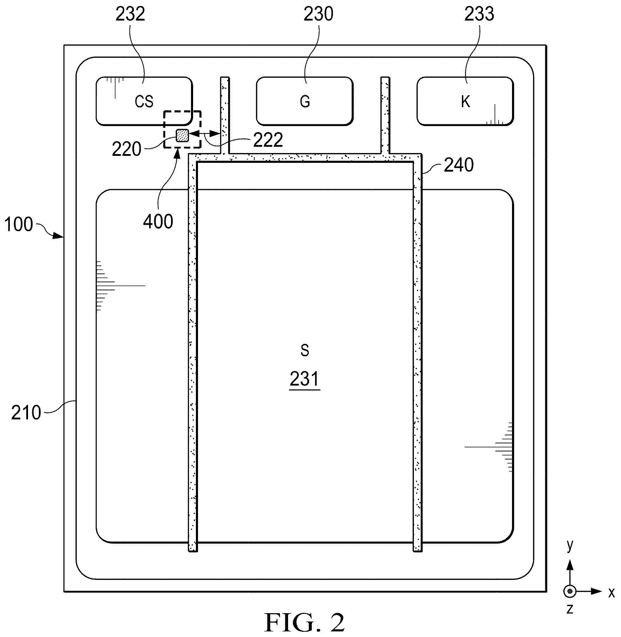

FIG. 2 illustrates a top view of MOSFET device 100 in accordance with embodiments of the present disclosure. The semiconductor die on which MOSFET device 100 is formed may have an active area edge 210. The MOSFET active area of MOSFET 110 may encompass the area within the active area edge 210, with the exception of the sense-FET active area 220 for sense-FET 120 as shown in FIG. 2. Although not shown in FIG. 2, MOSFET device 100 may further include an isolation area around the border of sense-FET active area 220 to isolate the sense-FET active area 220 from the surrounding MOSFET active area.

As shown in FIG. 2, MOSFET device 100 may include gate pad 230, source pad 231, current-sense pad 232, and Kelvin pad 233, each of which may be formed by a patterned portion of the top metal layer of the semiconductor die. For the purposes of the present disclosure, gate pad 230, source pad 231, current-sense pad 232, and Kelvin pad 233 shown in FIG. 2 may correspond to gate pad G, source pad S, current-sense pad CS, and Kelvin pad K shown in FIG. 1. As described in further detail below, MOSFET 110 and sense-FET 120 may be vertical FETs. Thus, MOSFET device 100 may further include a drain pad formed by a metallization on a back-side of the semiconductor die. In some embodiments, MOSFET device 100 may be formed with a double metal redistribution layer (RDL) option. Accordingly, the various pads shown in FIG. 2 may be formed on an upper second layer of metal, while further metal routing is included on a lower first layer of metal.

The multiple metal layers may facilitate the inclusion of various pads above the MOSFET active area. For example, current-sense pad 232 may be included on an upper second layer of metal, and may be coupled to the respective sources of the MOSFET cells forming sense-FET 120 in sense-FET active area 220 via metal routing on a lower first layer of metal. By including current-sense pad 232 on an upper second layer of metal, current-sense pad 232 may extend over a portion of the MOSFET active area of MOSFET 110. Accordingly, current-sense pad 232 may be sized according to any size and shape requirements for bonding without consuming chip area that can otherwise be used for the MOSFET active area of MOSFET 110. Sense-FET 120 may thus be monolithically integrated with MOSFET 110 without requiring additional space and cost that would otherwise be associated with the area of the current-sense pad 232.

As another example, gate runner 240 may be formed on a first metal layer (for example, by a patterned area of the first metal layer) and may couple a gate pad 230 that is formed on the second metal layer to a patterned polysilicon layer that, as described in further detail below with reference to FIG. 3, may form the MOSFET gate of MOSFET 110 and the sense-FET gate of sense-FET 120. In some embodiments, sense-FET 120, which is formed within the sense-FET active area 220 shown in FIG. 2, may be located at a distance 222 from gate runner 240 such that a parasitic sense-FET gate resistance based on the resistivity of the patterned polysilicon layer provides for a switching transient time of sense-FET 120 that corresponds to a switching transient time of MOSFET 110. For example, sense-FET 120 may have a parasitic sense-FET gate resistance 121, while MOSFET 110 has a parasitic MOSFET resistance 111 (illustrated in FIG. 1) based in part on the resistivity of the patterned polysilicon layer forming the respective gates of MOSFET 110 and sense-FET 120. In some embodiments, sense-FET 120 may be located at a distance 222 from gate runner 240 such that the parasitic sense-FET gate resistance 121 based on the resistivity of the patterned polysilicon layer provides for a transient switch-on and a transient switch-off time within ten percent of that for MOSFET 110 with a given gate drive signal received at gate pad 230. In other embodiments, sense-FET 120 may be located at a minimum distance (for example less than distance 222) from gate runner 240 to minimize parasitic sense-FET gate resistance 121 to provide for a transient switch-on time and a transient switch-off time faster than that for MOSFET 110 with a given gate drive signal received at gate pad 230. In such other embodiments, sense-FET 120 may thus be utilized by upstream current-sense circuitry to more quickly sense a short-circuit current through MOSFET device 100.

FIG. 3 illustrates a cross-section view of a plurality of MOSFET cells in accordance with embodiments of the present disclosure. The cross-section of the plurality of MOSFET cells shown in FIG. 3 may be representative of the cross-sections for cells of both MOSFET 110 and sense-FET 120. For illustrative purposes, the cross-section shown in FIG. 3 provides a zoomed in view of various MOSFET cells, allowing later figures and corresponding descriptions to illustrate higher-level features corresponding to different groups of cells located in different areas of the semiconductor die, including the MOSFET active area and the separate sense-FET active area.

As described above, MOSFET 110 and sense-FET 120 may be vertical FETs. Accordingly, MOSFET 110 and sense-FET 120 may be formed with vertical MOSFET cells as shown in FIG. 3. Each MOSFET cell may include source region 308 disposed within well region 306, which may in turn be disposed in epitaxial region 302. JFET region 304 may be disposed to the sides of well region 306 and may include a higher doping of the same conductivity type as epitaxial region 302. In some embodiments, and as shown in FIG. 3, the depth of JFET region 304 may be less than the depth of well region 306. In other embodiments, the depth of JFET region 304 may be equal the depth of well region 306. In embodiments where MOSFET 110 and sense-FET 120 are NMOS devices, epitaxial region 302, JFET region 304, and source region 308 may n-type regions, while well region 306 may be a p-type well region. In some embodiments, epitaxial region 302 may further couple to an n-type substrate, which may form the drain of the MOSFET cells. A further back-side metal layer coupled to the n-type substrate may in turn be used to form the common drain pad for MOSFET device 100, coupling to the drains of both MOSFET 110 and sense-FET 120.

As shown in FIG. 3, polysilicon layer 322 may be disposed above gate oxide layer 320 at a location extending from source region 308 across a portion of well region 306 to and/or abutting JFET region 304. The various instances of polysilicon layer 322 may form the gates of respective MOSFET cells. For example, a gate runner (such as gate runner 240 in FIG. 2) may distribute a gate voltage from a gate pad (such as gate pad 230 in FIG. 2) to various instances of polysilicon layer 322 which may be disposed, for example, along the x-axis (into the page) as shown in FIG. 3. During operation, when a voltage higher than threshold voltage is applied to the gate formed by polysilicon layer 322, a conduction channel may be formed under the gate and through the area of well region 306 located laterally between source region 308 and JFET region 304. Electrons may thus flow from source region 308, through well region 306, into JFET region 304, and down through epitaxial region 302 toward the drain contact on the bottom-side of the semiconductor substrate.

As further shown in FIG. 3, a dielectric layer 330 may be placed above various instances of source region 308 and various instances of polysilicon layer 322. Dielectric layer 330 may be formed with borophosphosilicate glass (BPSG), silicon dioxide, silicon nitride, or any other dielectric suitable to insulate the sources of the various MOSFET cells from the gates (formed by polysilicon layer 322) of the various MOSFET cells. Source contacts 335 may be formed through dielectric layer 330 to couple the source regions 308 of the various MOSFET cells to an above first metal layer 340. As described in further detail below, the first metal layer may be patterned to form (i) a first source metal that is located above the MOSFET active area and couples to source contacts of the plurality of MOSFET cells forming MOSFET 110, and (ii) a first current-sense metal that is located above the sense-FET active area and couples to source contacts of the plurality of MOSFET cells forming sense-FET 120.

The various features shown in FIG. 3 illustrate at a high-level the configuration and operation of MOSFET cells, similar to those used to form MOSFET 110 and sense-FET 120. Some embodiments, however, may include additional regions and/or layers not shown in FIG. 3. For example, a silicide layer may be disposed between source contacts 335 and source regions 308 to facilitate a low-ohmic contact therebetween. Further, an additional passivation layer may be located between polysilicon layer 322 and dielectric layer 330. In addition, a thin capping layer may be included as a liner for source contact 335 as well as between first metal layer 340 and dielectric layer 330.

FIG. 4A illustrates a top layout view of a MOSFET device in accordance with embodiments of the present disclosure. Specifically, FIG. 4A illustrates a top layout view of a first metal layer and a second metal layer for a portion of MOSFET device 100 corresponding to area 400 labeled in FIG. 2.

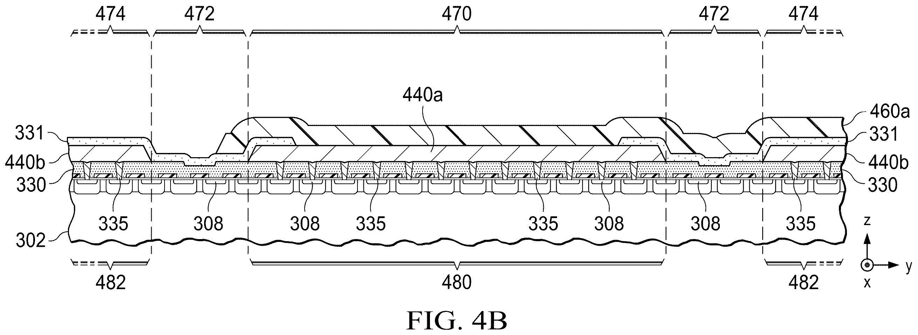

MOSFET device 100 may include a first current-sense metal 440a formed on a first metal layer of the semiconductor die. MOSFET device 100 may also include first source metal 440b formed on the first metal layer. For example, first current-sense metal 440a and first source metal 440b may be formed by separate patterned portions of the first metal layer. As shown in FIG. 4A, the first metal layer may be patterned to form first current-sense metal 440a and first source metal 440b with a gap 442 therebetween. As described in further detail below with reference to FIGS. 4B-4C, the first current-sense metal 440a may be located above a sense-FET active area and coupled to one or more source contacts of sense-FET 120. And as also described in further detail below with reference to FIGS. 4B-4C, the first source metal 440b may be located above a MOSFET active area and coupled to source contacts of a plurality of MOSFET cells that form MOSFET 110.

MOSFET device 100 may also include second current-sense metal 460a formed on a second metal layer. In addition, MOSFET device 100 may include second source metal 460b formed on the second metal layer. For example, second current-sense metal 460a and second source metal 460b may be formed by separate patterned portions of the second metal layer. As shown in FIG. 4A, the second metal layer may be patterned to form second current-sense metal 460a and second source metal 460b with a gap 462 therebetween.

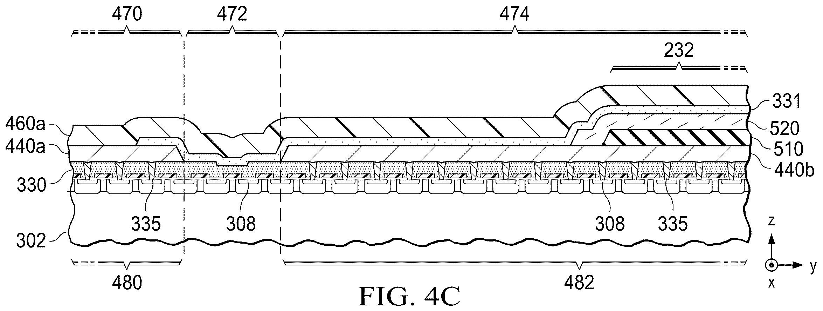

Second current-sense metal 460a may be coupled to first current-sense metal 440a. For example, second current-sense metal 460a may be coupled to first current-sense metal 440a in contact area 450, which may represent an area of the semiconductor die where the second current-sense metal 460a may be disposed directly on first current-sense metal 440a, thereby electrically coupling to first current-sense metal 440a. As described in further detail below with reference to FIG. 4C, current-sense pad 232 may be formed by the second current-sense metal 460a. For example, current-sense pad 232 may represent an exposed area of second current-sense metal 460a to which one or more bond wires may be coupled.

The source pad 231 (shown in FIG. 2) may be formed by second source metal 460b which may itself be formed on the second metal layer. For example, the source pad 231 shown in FIG. 2 may represent an exposed area of second source metal 460b to which one or more bond wires or bond ribbons may be coupled. Further, second source metal 460b may be coupled to underlying portions of first source metal 440b in various contact areas, for example, outside of area 400.

FIG. 4B illustrates a cross-section view of MOSFET device 100 in accordance with embodiments of the present disclosure. Specifically, FIG. 4B illustrates a cross-section along cut-line 4B shown in FIG. 4A.

As shown in FIG. 4B, first current-sense metal 440a may be coupled to the source contacts 335 for the plurality of MOSFET cells 480 within sense-FET active area 470. Similarly, first source metal 440b may be coupled to the source contacts 335 for the plurality of MOSFET cells 482 within MOSFET active area 474.

MOSFET device 100 may include isolation area 472 between the MOSFET active area 474 and the sense-FET active area 470. Isolation area 472 may include at least one dielectric layer insulating a plurality of underlying source regions 308 from the first metal layer and the second metal layer. For example, as shown in FIG. 4B, isolation area may include dielectric layer 330 (described above with reference to FIG. 3) above various underlying source regions 308. Isolation area 472 may be void of source contacts 335 punching through dielectric layer 330, thereby not connecting the source regions 308 of any MOSFET cells within isolation area 472 to any above metal routing. The MOSFET cells within isolation area 472 may thus be inactive. Although FIG. 4B illustrates isolation area 472 being void of source contacts 335 in order to make the MOSFET cells within isolation area 472 inactive, any suitable means may be utilized to make the cells within isolation area 472 inactive, or to otherwise separate the MOSFET cells that form MOSFET 110 in MOSFET active area 474 and the MOSFET cells that form sense-FET 120 in sense-FET active area 470. For example, in embodiments where MOSFET 110 and sense-FET 120 are NMOS devices, an additional p+ well may be formed in, or in place of, the n-type JFET region 304 for one or more of the MOSFET cells within isolation area 472, including for example the MOSFET cell within isolation area 472 that is closest to sense-FET active area 470.

Isolation area 472 may also include a gap in the first metal layer separating first source metal 440b and first current-sense metal 440a. The gap may be filled at least in part by one or more dielectric layers insulating first source metal 440b and first current-sense metal 440a. For example, as shown in FIG. 4B, the gap in the first metal layer separating first source metal 440b and first current-sense metal 440a may be filled in part by dielectric 331. Dielectric 331 may be formed with silicon dioxide, for example, or any other dielectric material suitable to electrically insulate regions on opposing sides of dielectric 331. As shown in FIG. 4B, dielectric 331 may, in addition to dielectric layer 330, further insulate a plurality of underlying source regions 308 from any routing included on the first metal layer and the second metal layer.

As shown in FIG. 4B, second current-sense metal 460a is coupled to first current-sense metal 440a within sense-FET active area 470. In addition, second current-sense metal 460a may extend from sense-FET active area, over a portion of isolation area 472, and over a portion of the MOSFET active area 474. For example, second current-sense metal 460a may extend along the y-axis shown in FIG. 4A and FIG. 4B to current-sense pad 232. Referring back to FIG. 4B, dielectric 331 may insulate the first source metal 440b from the first current-sense metal 440a and second current-sense metal 460a. Accordingly, second current-sense metal 460a may be routed over a portion of the MOSFET active area 474 while still including MOSFET cells 482 under the second current-sense metal 460a as part of the plurality of MOSFET cells forming MOSFET 110. Accordingly, sense-FET 120 may be monolithically integrated with MOSFET 110 without sacrificing semiconductor die area (and associated costs) that would otherwise be required to include a current-sense pad.

FIG. 4C illustrates a cross-section view of MOSFET device 100 in accordance with embodiments of the present disclosure. Specifically, FIG. 4C illustrates a cross-section view of MOSFET device 100 along cut-line 4C shown in FIG. 4A.

As described above with reference to FIG. 4B, and as shown further in FIG. 4C, second current-sense metal 460a may be formed on the second metal layer above the first metal layer that is patterned to form the first current-sense metal 440a and the first source metal 440b. Second current-sense metal 460a may couple to first current-sense metal at a gap in dielectric 331 over the sense-FET active area 470. Second current-sense metal 460a may further extend over isolation area 472 and over a portion of MOSFET active area 474. As shown in FIG. 4C, additional dielectric layers 510 and 520 may be placed under the portion of second current-sense metal 460a that forms current-sense pad 232. Dielectric layers 510 and 520 may be formed with silicon dioxide, or any other dielectric material suitable to help insulate second current-sense metal 460a from underlying portions of first source metal 440b. Further, dielectric layers 510 and 520 may provide additional structural support to protect the portions of MOSFET active area 474 under current-sense pad 232 from physical stresses that may be incurred at current-sense pad 232 during a wire bonding process.

Embodiments herein may include a MOSFET device. The MOSFET device may include (i) a silicon carbide MOSFET comprising a plurality of vertical MOSFET cells, (ii) a sense-FET monolithically integrated with the silicon carbide MOSFET, (iii) a gate pad coupled to a MOSFET gate and a sense-FET gate, (iv) a drain pad coupled to a MOSFET drain and a sense-FET drain, (v) a first source metal on a first metal layer, the first source metal located above a MOSFET active area and coupled to source contacts of the plurality of vertical MOSFET cells, (vi) a first current-sense metal on the first metal layer, the first current-sense metal located above a sense-FET active area and coupled to one or more source contacts of the sense-FET, (vii) an isolation area between the MOSFET active area and the sense-FET active area, the isolation area including at least one dielectric layer insulating the first source metal from the first current-sense metal, (viii) a source pad formed by a second source metal on a second metal layer, wherein the second source metal is coupled to the first source metal, and (ix) a current-sense pad formed by a second current-sense metal on the second metal layer, wherein the second current-sense metal is coupled to the first current-sense metal and extends over a portion of the MOSFET active area. The MOSFET device may have one or more of the following additional elements in any combination. Element 1: wherein the MOSFET and the sense-FET are vertical FETs. Element 2: wherein the at least one dielectric layer included in the isolation area further insulates a plurality of underlying source regions from the first metal layer and the second metal layer. Element 3: wherein the MOSFET device further comprising a gate runner formed on the first metal layer, wherein the gate runner couples the gate pad formed on the second metal layer to a patterned polysilicon layer forming the MOSFET gate and the sense-FET gate. Element 4: wherein the sense-FET is located at a distance from the gate runner such that a parasitic sense-FET gate resistance based on a resistivity of the polysilicon layer provides for a switching transient time of the sense-FET that is faster than a switching transient time of the MOSFET.

Although examples have been described above, other modifications and variations may be made from this disclosure without departing from the spirit and scope of these examples. The above descriptions of various embodiments illustrate the principles of the invention. Numerous variations and modifications will become apparent to those skilled in the art based on the above disclosure. The following claims are intended to embrace all such variations and modifications.

## Claims

1. A MOSFET device, comprising:
a MOSFET comprising a plurality of MOSFET cells formed on a semiconductor die;
a sense-FET monolithically integrated with the MOSFET on the semiconductor die;
a gate pad coupled to a MOSFET gate and a sense-FET gate;
a drain pad coupled to a MOSFET drain and a sense-FET drain;
a first source metal on a first metal layer, the first source metal located above a MOSFET active area and coupled to source contacts of the plurality of MOSFET cells;
a source pad formed by a second source metal on a second metal layer, wherein the second source metal is coupled to the first source metal;
a first current-sense metal on the first metal layer, the first current-sense metal located above a sense-FET active area and coupled to one or more source contacts of the sense-FET; and
a current-sense pad formed by a second current-sense metal on the second metal layer, wherein the second current-sense metal is coupled to the first current-sense metal and extends over a portion of the MOSFET active area.

2. The MOSFET device of claim 1, wherein the semiconductor die is a silicon carbide semiconductor die.

3. The MOSFET device of claim 1, wherein the MOSFET and the sense-FET are vertical FETs.

4. The MOSFET device of claim 1, wherein the MOSFET and the sense-FET are NMOS devices.

5. The MOSFET device of claim 1, further comprising a dielectric insulating the first source metal from the first current-sense metal and the second current-sense metal.

6. The MOSFET device of claim 1, further comprising an isolation area between the MOSFET active area and the sense-FET active area.

7. The MOSFET device of claim 6, wherein the isolation area includes a gap in the first metal layer separating the first source metal and the first current-sense metal, wherein the gap is filled at least in part by one or more dielectric layers insulating the first source metal and the first current-sense metal.

8. The MOSFET device of claim 6, wherein the isolation area includes at least one dielectric layer insulating a plurality of underlying source regions from the first metal layer and the second metal layer.

9. The MOSFET device of claim 1, further comprising a gate runner formed on the first metal layer, wherein the gate runner couples the gate pad formed on the second metal layer to a patterned polysilicon layer forming the MOSFET gate and the sense-FET gate.

10. The MOSFET device of claim 9, wherein the sense-FET is located at a distance from the gate runner such that a parasitic sense-FET gate resistance based on a resistivity of the patterned polysilicon layer provides for a switching transient time of the sense-FET that is faster than a switching transient time of the MOSFET.

11. A silicon carbide MOSFET device, comprising:
a silicon carbide MOSFET comprising a plurality of vertical MOSFET cells;
a sense-FET monolithically integrated with the silicon carbide MOSFET;
a gate pad coupled to a MOSFET gate and a sense-FET gate;
a drain pad coupled to a MOSFET drain and a sense-FET drain;
a first source metal on a first metal layer, the first source metal located above a MOSFET active area and coupled to source contacts of the plurality of vertical MOSFET cells;
a source pad formed by a second source metal on a second metal layer, wherein the second source metal is coupled to the first source metal;
a first current-sense metal on the first metal layer, the first current-sense metal located above a sense-FET active area and coupled to one or more source contacts of the sense-FET; and
a current-sense pad formed by a second current-sense metal on the second metal layer, wherein the second current-sense metal is coupled to the first current-sense metal and extends over a portion of the MOSFET active area.

12. The silicon carbide MOSFET device of claim 11, further comprising a dielectric insulating the first source metal from the first current-sense metal and the second current-sense metal.

13. The silicon carbide MOSFET device of claim 11, further comprising an isolation area between the MOSFET active area and the sense-FET active area.

14. The silicon carbide MOSFET device of claim 13, wherein the isolation area includes a gap in the first metal layer separating the first source metal and the first current-sense metal, wherein the gap is filled at least in part by one or more dielectric layers insulating the first source metal and the first current-sense metal.

15. The silicon carbide MOSFET device of claim 13, wherein the isolation area includes at least one dielectric layer insulating a plurality of underlying source regions from the first metal layer and the second metal layer.
